(19) Europäisches Patentamt / European Patent Office / Office européen des brevets

(11) **EP 4 432 334 A1**

(12) **EUROPEAN PATENT APPLICATION**
published in accordance with Art. 153(4) EPC

(43) Date of publication:
**18.09.2024 Bulletin 2024/38**

(21) Application number: **22892424.7**

(22) Date of filing: **21.09.2022**

(51) International Patent Classification (IPC):
**H01L 21/66** (2006.01)

(52) Cooperative Patent Classification (CPC):
**H01L 22/00**

(86) International application number:
**PCT/JP2022/035107**

(87) International publication number:
**WO 2023/084923 (19.05.2023 Gazette 2023/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.11.2021 JP 2021183205**

(71) Applicant: **SUMCO CORPORATION
Minato-ku, Tokyo 105-8634 (JP)**

(72) Inventors:
• **FUMOTO, Shuto
Tokyo 105-8634 (JP)**
• **SAMATA, Shuichi
Tokyo 105-8634 (JP)**
• **MITSUGI, Noritomo
Tokyo 105-8634 (JP)**

(74) Representative: **Kraus & Lederer PartGmbB
Thomas-Wimmer-Ring 15
80539 München (DE)**

(54) **METHOD FOR ASSESSING SEMICONDUCTOR SAMPLE, DEVICE FOR ASSESSING SEMICONDUCTOR SAMPLE, AND METHOD FOR PRODUCING SEMICONDUCTOR WAFER**

(57) Provided is an evaluation method of a semiconductor sample, the method including subjecting a semiconductor sample to be evaluated to measurement with a photoconductivity decay method to acquire a decay curve; subjecting the decay curve to signal data processing by a model expression including an exponential decay term and a constant term; and determining a recombination lifetime of the semiconductor sample from an expression of exponential decay obtained by the above signal data processing.

Fig. 5

## Description

[CROSS REFERENCE TO RELATED APPLICATIONS]

This application claims the benefit of priority to Japanese Patent Application No. 2021-183205 filed on November 10, 2021, which is expressly incorporated herein by reference in its entirety.

[Technical Field]

The present invention relates to a method of evaluating a semiconductor sample, an evaluation device of a semiconductor sample and a method of manufacturing a semiconductor wafer.

[Background Art]

The photoconductivity decay method is generally referred to as the PCD method, and is widely used for evaluation of a semiconductor sample.
    PTL 1: Japanese Patent Application Publication No. 2019-012740 (the entire contents of which are herein incorporated by reference)
    PTL 2: Japanese Patent Application Publication No. S58-181549 (the entire contents of which are herein incorporated by reference)
    NPL 1: Usami Akira, Sone Fukuyasu, Murai Kouji, Sano Kenji, Laser Study 1984 vol. 12, no. 10, p. 585-594 (the entire contents of which are herein incorporated by reference)
    NPL 2: Usami Akira, Kandatsu Shinichi, Kudo Bossi, Applied Physics, 1980, vol. 49, no. 12, p. 1192-1197 (the entire contents of which are herein incorporated by reference)

[Summary of Invention]

For example, for a silicon wafer, i.e., one example of a semiconductor sample, a measuring method of a recombination lifetime by the PCD method has been standardized (SEMI MF1535. Test Methods 2or Carrier Recombination Lifetime in Silicon Wafers by Noncontact Measurement of Photoconductivity Decay by Microwave Reflectance. 2007 (the entire contents of which are herein incorporated by reference); hereinafter, referred to as the " SEMI standard").
The SEMI standard describes the primary mode method and the 1/e lifetime method as a method of determining a recombination lifetime by the PCD method. With the primary mode method, in the decay curve acquired by measurement with the PCD method, the time constant within a range recognizable as the exponential decay is assumed to be a primary mode lifetime $\tau_1$. The primary mode lifetime $\tau_1$ is expressed by expression: $1/\tau_1 = 1/\tau_b + 1/\tau_s$ where $\tau_b$ represents a bulk lifetime and $\tau_s$

represents a lifetime of surface recombination. On the other hand, with the 1/e lifetime method, the 1/e lifetime $\tau_e$ is expressed by the expression: $\tau_e = t_1 - t_0$ where $t_0$ represents a time during which excess carriers are excited in the semiconductor sample by an optical pulse, and $t_1$ represents a time until the signal intensity becomes 1/e times ($V_1 = V_0/e$) the peak value $V_0$ of the signal intensity V.
With the above method, under the assumption that the decay of the excess carrier density would be in a form of exponential decay due to contribution of only the SRH (Shockley-Read-Hall) recombination (i.e., bulk recombination), the recombination lifetime is calculated. However, as described in, for example, PTL 2, in addition to the bulk lifetime $\tau_b$ determined by purity, crystal defect, and the like of the semiconductor crystal of a semiconductor sample to be evaluated, the surface recombination lifetime $\tau_s$ is also involved in the recombination lifetime (described as the "effective lifetime $\tau_{eff}$" in PTL 2). For example, for a silicon wafer with a high cleanliness, the contribution of SRH recombination is relatively weakened. As a result, the contribution of the surface recombination, or the like becomes non-negligible. For this reason, for example, when a silicon wafer with a high cleanliness is subjected to the PCD measurement, for example, under the influence of the surface recombination at the end of decay, distortion is caused in the decay curve, resulting in non-exponential decay. For example, in such a case, with the above method to be performed under the assumption that decay of the excess carrier density would be in a form of the exponential decay due to contribution of only the SRH recombination, it is difficult to measure the recombination lifetime with precision.
As for the surface recombination, PTL 1, PTL 2, NPL 1, and NPL 2 propose the evaluation method in consideration of the surface recombination. However, the method proposed in PTL 1 requires two measurements per sample, and hence is not suitable for such a sample whose recombination lifetime has the dependency on the elapsed time from the surface treatment, and with the method, preparation of the data base is necessary for analysis. Because of these points, the method proposed in PTL 1 is poor in versatility. Further, all of the methods proposed in PTL 2, NPL 1, and NPL 2 are methods in which the deviation from the exponential decay caused at the initial stage of decay under the influence of higher modes than the primary mode is removed as the influence of the surface recombination. Therefore, with the methods, it is not possible to reduce or remove the influence of the deviation from the exponential decay at the end of decay.
In view of the foregoing circumstances, one aspect of the present invention provides a new evaluation method of evaluating a recombination lifetime of a semiconductor sample with precision.
One aspect of the present invention relates to an evaluation method of a semiconductor sample (which will be hereinafter also described as an "evaluation method"), the method including:

subjecting a semiconductor sample to be evaluated to measurement with a photoconductivity decay method to acquire a decay curve;

subjecting the decay curve to signal data processing by a model expression including an exponential decay term and a constant term; and

determining a recombination lifetime of the semiconductor sample from an expression of exponential decay obtained by the above signal data processing.

In one embodiment, the above evaluation method can further include:

performing the signal data processing to cancel the constant term in the model expression to acquire the expression of exponential decay; and

determining a time constant $\tau_B^{-1} + \tau_S^{-1}$ from the expression of exponential decay, where $\tau_B$ is a SRH recombination lifetime, and $\tau_S$ is a surface recombination lifetime.

In one embodiment, the above signal data processing can include repetition of an operation of sampling a time series signal modeled by the model expression to obtain a difference.

In one embodiment, the above evaluation method can further include carrying out auto scaling for determining a sampling region for performing the sampling.

In one embodiment, the above auto scaling can determine a region, where the influence of auger recombination is small and the influence of noise is small, as the sampling region.

In one embodiment, the above model expression can be (1') expression below:

$$x_i(t_i) = A \times \exp[-(\tau_B^{-1} + \tau_S^{-1})t_i] - C \cdots (1')$$

(in the expression (1'), $t_i$: elapsed time after excitation light irradiation, $x_i(t_i)$: signal intensity at elapsed time $t_i$, $\tau_B$: SRH recombination lifetime, $\tau_S$: surface recombination lifetime, A, C: constant).

One aspect of the present invention relates to an evaluation device of a semiconductor sample (which will be hereinafter also described as an "evaluation device"), the device including:

a measurement part which subjects a semiconductor sample to be evaluated to measurement with a photoconductivity decay method to acquire a decay curve;

a processing part which subjects the decay curve to signal data processing by a model expression including an exponential decay term and a constant term; and

a recombination lifetime calculation part which determines a recombination lifetime of the semiconductor sample from an expression of exponential decay obtained by the signal data processing.

In one embodiment, the above processing part can execute:

performing the signal data processing to cancel the constant term in the model expression to acquire the expression of exponential decay; and

determining a time constant $\tau_B^{-1} + \tau_S^{1}$ from the expression of exponential decay, where $\tau_B$ is a SRH recombination lifetime, and $\tau_S$ is a surface recombination lifetime.

In one embodiment, the above signal data processing can include repetition of an operation of sampling a time series signal modeled by the model expression to obtain a difference.

In one embodiment, the above processing part can execute auto scaling for determining a sampling region for performing the sampling.

In one embodiment, the above processing part can determine a region, where the influence of auger recombination is small and the influence of noise is small, as a sampling region by the auto scaling.

In one embodiment, the above model expression can be the expression (1') previously described.

One aspect of the present invention relates to a method of manufacturing a semiconductor wafer, the method including:

manufacturing a semiconductor wafer lot including a plurality of semiconductor wafers;

extracting at least one semiconductor wafer from the semiconductor wafer lot;

evaluating the extracted semiconductor wafer by the above evaluation method; and

subjecting a semiconductor wafer of the semiconductor wafer lot, which is same as that of the semiconductor wafer evaluated as a good product as a result of the evaluation, to preparation for shipment as a product semiconductor wafer.

One aspect of the present invention relates to a method of manufacturing a semiconductor wafer, the method including:

manufacturing a semiconductor wafer to be evaluated under a test manufacturing condition;

evaluating the manufactured semiconductor wafer to be evaluated by the above evaluation method of the semiconductor sample;

determining a manufacturing condition, obtained by adding a change to the test manufacturing condition, as an actual manufacturing condition, or determining the test manufacturing condition as an actual manufacturing condition, based on the result of the evaluation; and
manufacturing a semiconductor wafer under the determined actual manufacturing condition.

In accordance with one aspect of the present invention, it is possible to provide a new evaluation method of evaluating the recombination lifetime of a semiconductor sample with precision.

[Brief Description of Drawings]

[Fig. 1] Fig. 1 is an explanatory view of a specific example of signal data processing.
[Fig. 2] Fig. 2 is an explanatory view of a specific example of signal data processing.
[Fig. 3] Fig. 3 is an explanatory view of a specific example of signal data processing.
[Fig. 4] Fig. 4 is an explanatory view of one example of the evaluation method of a semiconductor sample in accordance with one aspect of the present invention.
[Fig. 5] Fig. 5 shows a result of comparison between one example (new method) of the evaluation method of a semiconductor sample in accordance with one aspect of the present invention and a conventional method.
[Fig. 6] Fig. 6 shows a result of comparison between one example (new method) of the evaluation method of a semiconductor sample in accordance with one aspect of the present invention and a conventional method.
[Fig. 7] Fig. 7 shows a result of comparison between one example (new method) of the evaluation method of a semiconductor sample in accordance with one aspect of the present invention and a conventional method.
[Fig. 8] Fig. 8 shows a decay curve obtained by subjecting an n type silicon wafer (single crystal silicon wafer) to a chemical passivation treatment as a surface treatment, followed by measurement with the $\mu$-PCD method.
[Fig. 9] Fig. 9 shows a fitting curve resulting from primary mode lifetime fitting of the decay curve shown in Fig. 8 and a fitting curve resulting from 1/e lifetime fitting thereof.

[Description of Embodiments]

[Evaluation method of semiconductor sample]

The evaluation method of a semiconductor sample in accordance with one aspect of the present invention includes subjecting a semiconductor sample to be evaluated to a photoconductivity decay method to acquire a decay curve; fitting the decay curve by a model expression including an exponential decay term and a constant term to form a fitting curve; and determining the recombination lifetime of the semiconductor sample from the fitting curve.
Below, the above evaluation method will be further described in details.

<Semiconductor sample to be evaluated>

The evaluation object of the above evaluation method may only be a semiconductor sample. Examples of the semiconductor sample may include various semiconductor samples such as single crystal silicon, polycrystal silicon, and SiC. The shape and dimensions of the semiconductor sample to be evaluated have no particular restriction. As one example, the semiconductor sample to be evaluated can be a semiconductor sample in a wafer shape, namely, a semiconductor wafer, for example, a single crystal silicon wafer. However, the semiconductor sample to be evaluated may be in a shape other than a wafer shape. Further, the semiconductor sample to be evaluated also has no particular restriction on the conductivity type, and may be of n type or of p type.

<Measurement with photoconductivity decay method>

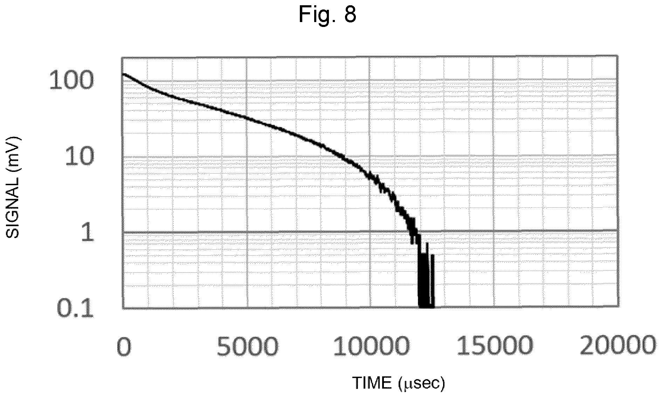

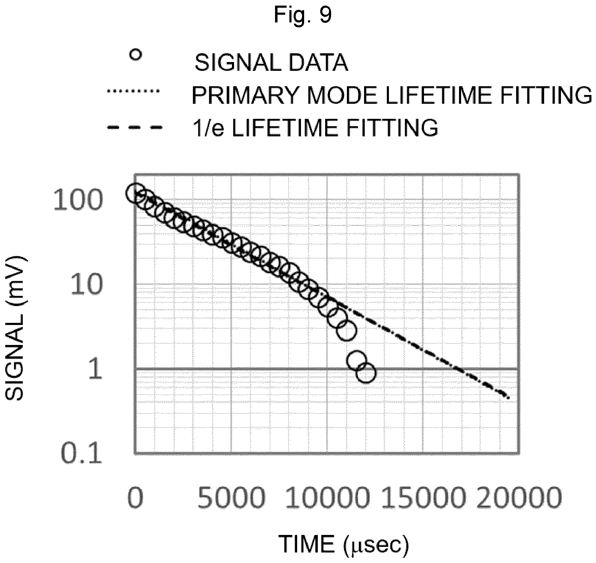

The measurement with the photoconductivity decay method can be performed by a commercially available PCD device or a PCD device with a known configuration. A known technology is applicable to the measurement with the photoconductivity decay method in the above evaluation method. Specific examples of the photoconductivity decay method may include a microwave photoconductivity decay ($\mu$-PCD) method. However, the measurement with the photoconductivity decay method in the evaluation method is not limited to that with the $\mu$-PCD method. For example, in consideration of the maximum carrier injection amount of a general $\mu$-PCD device, when the semiconductor sample to be evaluated is p type silicon, the resistivity is preferably about 1 to 100 $\Omega$cm, and when the semiconductor sample to be evaluated is n type silicon, the resistivity is preferably about 0.5 to 100 $\Omega$cm.
By the measurement with the photoconductivity decay method, a decay curve is acquired. The decay curve is specifically a curve indicative of a change with time of the signal intensity with respect to the elapsed time after excitation light irradiation. The "elapsed time after excitation light irradiation" is particularly the elapsed time from the time point after completion of excitation light irradiation. Further, for example, with the $\mu$-PCD method, the signal intensity is the intensity of a reflection microwave. Fig. 8 shows a decay curve obtained by subjecting an n type silicon wafer (single crystal silicon wafer) to a chemical passivation treatment as a surface treatment, followed by measurement with the $\mu$-PCD method. The decay curve shown in Fig. 8 is distorted at from the intermediate region to the end region under the influence of the surface recombination. Fig. 9 shows a fitting curve resulting from primary mode lifetime fitting described in the SEMI standard of the decay curve shown in Fig. 8 and a fitting curve resulting from the 1/e lifetime fitting described in the SEMI standard. Neither of the two fitting curves shown in Fig. 9 conforms to the decay curve particularly at from the intermediate region to the end region. This is due to the following: with the primary mode method and the 1/e lifetime method, fitting is performed under the assumption that decay of the excess carrier density would be in a shape of exponential decay by the contribution of only the SRH recombination.

In contrast, with the above evaluation method, as described in details below, by subjecting the decay curve to signal data processing, it becomes possible to determine the recombination lifetime with precision.

<Signal data processing on decay curve>

With the above evaluation method, signal data processing on the decay curve is performed using a model expression including an exponential decay term and a constant term. The present inventors consider that the decay curve in the case where surface recombination occurs is properly expressed by the expression including an exponential decay term and a constant term, preferably, the expression in which the constant term is subtracted from the exponential decay term. Such an expression is subjected to signal data processing of canceling the constant term, leaving only the exponential decay term. Namely, an expression of exponential decay is obtained. By using the expression of exponential decay, as the value including the influences of the SRH recombination and surface recombination, the value of recombination lifetime can be determined. As a result of this, it becomes possible to determine the recombination lifetime of the semiconductor sample to be evaluated with precision. Below, such signal data processing will be further described in details.

The function x(t) can be approximately expressed by the following expression (1):

$$x(t) = A \times \exp[-(\tau_B^{-1} + \tau_S^{-1})t] - C \cdots (1)$$

where x [1/cm$^3$] represents the excess carrier density, and x(t) represents the function of time.

In the expression (1), $\tau_B$ represents the SRH recombination lifetime, and the unit is, for example, $\mu$sec, $\tau_s$ represents the surface recombination lifetime, and the unit is, for example, $\mu$sec. A and C each independently represent a constant [1/cm$^3$], and preferably represent a positive constant. A and C are each a constant determined depending upon $\tau_B^{-1} + \tau_s^{-1}$. The expression (1) is a preferable function under the condition where the excess carrier density is larger than the carrier density in an equilibrium state with the excess carrier density as the function of time x(t) when both of SRH recombination and surface recombination by surface level contribute to the recombination lifetime.

An example of the model expression for performing signal data processing based on the expression (1) may be the following expression (1').

$$xi(ti) = A \times \exp[-(\tau_B^{-1} + \tau_S^{-1})ti] - C \cdots (1')$$

In the expression (1'), ti is the elapsed time after excitation light irradiation, xi(ti) is the signal intensity at the elapsed time ti, and the unit is, for example, mV, $\tau_B$ is the SRH recombination lifetime, $\tau_S$ is the surface recombination lifetime, and A and C are each independently a constant, and the unit is, for example, mV. The model expression (1') includes an exponential decay term and a constant term, and specifically an expression in which the constant term "C" is subtracted from the exponential decay term "A $\times$ exp[-($\tau_B^{-1}$ + $\tau_S^{-1}$)ti]". The expression (1') is one example of the model expression. For example, when the model expression including the constant term as the expression (1') is subjected to signal data processing for canceling the constant term, only the exponential decay term is left. For this reason, it is possible to determine the time constant $\tau_B^{-1}+\tau_S^{-1}$ (the sum of the reciprocal of the surface recombination lifetime and the reciprocal of the SRH recombination lifetime) with the exponential decay approximation method. The reciprocal of $\tau_B^{-1}$ + $\tau_S^{-1}$ thus determined can be adopted as the value of the recombination lifetime of the semiconductor sample to be evaluated. As the exponential decay approximation method, a general exponential decay approximation method such as the primary lifetime method or the 1/e lifetime method can be used.

Below, by taking the case where the model expression is the expression (1') as an example, a specific example of signal data processing will be described. However, the signal data processing described below is one example, and the present invention is not limited to such an example.

Signal data processing can include repetition of an operation of determining a sampling region in the decay curve acquired by measurement with the photoconductivity decay method, and sampling the time series signal (particularly, a measurement point on the decay curve) modeled by the model expression in the sampling region, and taking a difference. Determination of the sampling region can be performed by, for example, auto scaling. Specific examples thereof may include the following method of example, with the following method, the region, where the influence of auger recombination is small and the influence of noise is small, can be determined as the sampling region. Namely, the region largely affected by auger recombination, and with a high signal intensity, and the region largely affected by a noise and with a low signal intensity are eliminated in the decay curve acquired by measurement with the photoconductivity decay method. As a result, it becomes possible to set the region strongly affected by SRH recombination and surface recombination as the sampling region.

First, as the starting point of the sampling region, a position with an arbitrary signal intensity (e.g., 60% of the peak value) is set, and signal data processing is carried out one time. For the calculation result obtained by the signal data processing, the value that can be the index of the degree of conformance to exponential decay such as a $R^2$ value or a sum of squared residuals is calculated. The degree of conformance to exponential decay is evaluated by whether such a calculated value of the index satisfies a preset threshold value, or not.

When the calculated value satisfies the preset threshold value (as one example, $R^2 \geq 0.99$), the starting point of the sampling region set as described above can be determined as the starting point of the sampling region for carrying out signal data processing.

When the calculated value does not satisfy the preset threshold value (as one example, $R^2 \geq 0.99$), the starting point of the sampling region is shifted to the lower signal intensity side, and recalculation is carried out. Recalculation can be carried out one time, two times, or more. When the evaluation result upon recalculation satisfies the preset threshold value, the starting point at the recalculation can be determined as the starting point of the sampling region.

The end point of the sampling region can be at the position at which the SN ratio (Signal-to-Noise Ratio) is equal to, or smaller than the preset threshold value. The SN ratio can be calculated by, for example, the following expression. The threshold value of the SN ratio can be, for example, 5 dB or less. The position at which the SN ratio of the signal is 0 dB, namely, the position at which the noise and the signal are at the same level is preferably determined as the end point.

SN ratio [dB] = $20\log_{100}$ [(dispersion of signal an arbitrary time) / (dispersion of noise in equilibrium state)]

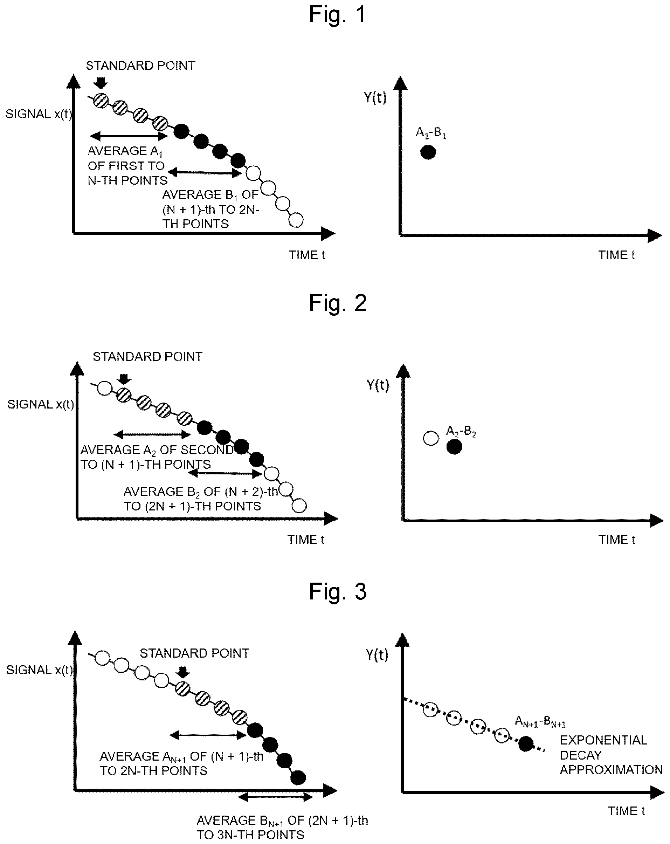

Figs. 1 to 3 are each an explanatory view of a specific example of signal data processing. Signal data processing can be performed, for example, with the number of sampling points as 3 N points in the following manner. Herein, N is an arbitrary integer, and can be, for example, 2 or more. Further, N can be, for example, 333 or less when the number of all points of signal data is assumed to be 1000. Namely, N can be an integer of, for example, "T × 1/3" or less when the number of all points of signal data is assumed to be T

First, with the starting point (first point) as the standard, the average $A_1$ of first to N-th points, and the average $B_1$ of (N+1)-th to 2N-th points are calculated (see Fig. 1).

$$A_1 = \{x(t_1) + x(t_2) + \cdots + x(t_N)\}/N$$

$$B_1 = \{x(t_{N+1}) + x(t_{N+2}) + \cdots + x(t_{2N})\}/N$$

The value obtained by subtracting $B_1$ from $A_1$ is assumed to be $Y(t_1)$.

$$Y(t_1) = A_1 - B_1$$

Then, with the second point as the standard, the average $A_2$ of second to (N+1)-th points and the average $B_2$ of (N+2)-th to (2N+1)-th points are calculated (see Fig. 2).

$$A_2 = \{x(t_2) + x(t_3) + \cdots + x(t_{N+1})\}/N$$

$$B_2 = \{x(t_{N+2}) + x(t_{N+3}) + \cdots + x(t_{2N+1})\}/N$$

The value obtained by subtracting $B_2$ from $A_2$ is assumed to be $Y(t_2)$.

$$Y(t_2) = A_2 - B_2$$

The same calculation is continued. Finally, the average $A_{N+1}$ of (N+1)-th to 2N-th points and the average $B_{N+1}$ of (2N+1)-th to 3N-th points are calculated (see Fig. 3).

$$A_{N+1} = \{x(t_{N+1}) + x(t_{N+2}) + \cdots + x(t_{2N})\}/N$$

$$B_{N+1} = \{x(t_{2N+1}) + x(t_{2N+2}) + \cdots + x(t_{3N})\}/N$$

The value obtained by subtracting $B_{N+1}$ from $A_{N+1}$ is assumed to be $Y(t_{N+1})$.

$$Y(t_{N+1}) = A_{N+1} - B_{N+1}$$

For the time series signal data row obtained by continuing the calculation, the constant term in the expression (1') is canceled, resulting in the following expression (2) of the exponential decay. The common exponential decay approximation method is applied to the expression (2). As a result, the time constant $\tau_B^{-1} + \tau_S^{-1}$ can be determined. The "$\tau_B^{-1} + \tau_S^{-1}$" determined in this manner can be adopted as the value of the recombination lifetime of the semiconductor sample to be evaluated. Examples of the exponential decay approximation method may include the primary mode method, and the 1/e lifetime method.

$$Y(t) = A' \times \exp[-(\tau_B^{-1} + \tau_S^{-1})t] \cdots (2)$$

(A': arbitrary constant)

<Specific embodiment of evaluation method>

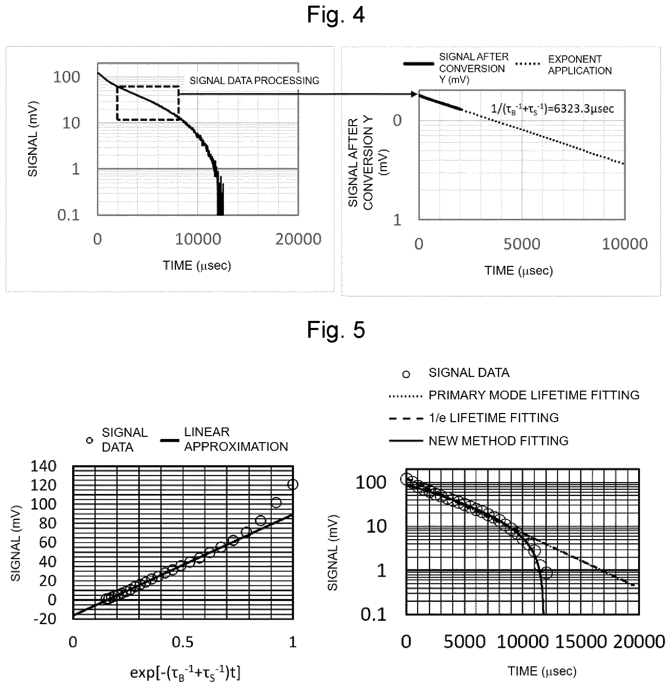

Fig. 4 is an explanatory view of one example of the evaluation method of a semiconductor sample in accordance with one aspect of the present invention.

The decay curve shown in the left-hand side view of Fig. 4 is the same as the decay curve shown in Fig. 8, and is the decay curve obtained by subjecting an n type silicon wafer (single crystal silicon wafer, resistivity: 10 $\Omega$cm) to a chemical passivation treatment as the surface treatment, followed by the measurement with the $\mu$-PCD method. The maximum carrier injection amount of $\mu$-PCD herein was about 1 E17/cm$^3$. "E17" represents "$\times 10^{17}$".

For the decay curve shown in the left-hand side view of Fig. 4, using the expression (1') as the model expression, as described previously with reference to Figs. 1 to 3, with the number of sampling points as 3N points, signal data processing was performed. The starting point of the sampling region was determined by the method previously described with the threshold value as "$R^2 \geq 0.99$". The end point of the sampling region was assumed to be the position at which the SN ratio was 0 dB as described previously.

By performing the above signal data processing, the constant term of the expression (1') is canceled, resulting in a straight line (a solid line in a right-hand side view of Fig. 4) of the linear expression of the expression (2) including only the exponential decay term. To the linear expression, the primary mode method is applied, thereby determining the time constant $\tau_B^{-1} + \tau_S^{-1}$. The recombination lifetime determined as the reciprocal of the time constant $\tau_B^{-1} + \tau_S^{-1}$ (in Table 1, Example 1) was the value shown in Table 1.

The recombination lifetimes determined by applying the primary mode method described in the SEMI standard and the 1/e method described in the SEMI standard to the decay curve shown in the left-hand side view of Fig. 4, respectively are also shown in Table 1 together.

[Table 1]

| Primary mode method | 3453. 1 $\mu$ sec |
| --- | --- |
| 1/e lifetime method | 3510. 5 $\mu$ sec |
| Examp e 1 | 6323. 3 $\mu$ sec |

From the results shown in Table 1, it can be confirmed that, with the primary mode method and the 1/e lifetime method of the conventional method, the value of the recombination lifetime is underestimated by about 60% as compared with Example 1.

Then, the function of the expression (1) being the function of time close to the actually measured decay was confirmed in the following manner.

First, in order to determine the residual undetermined parameter constants A and C in the expression (1), fitting was performed in the following manner.

Use of the time constant $\tau_B^{-1} + \tau_S^{-1}$ determined in the above Example causes the expression (1) to take the form of an expression linear with respect to $\exp[-(\tau_B^{-1} + \tau_S^{-1})t]$. Namely, in the sampling region determined by auto scaling, the decay curve can be linearly approximated with respect to $\exp[-(\tau_B^{-1} + \tau_S^{-1})t]$ as the left-hand side view of Fig. 5. Accordingly, the constants A and C can be obtained as the slope and the section.

When the expression (1) is applied using the time constant $\tau_B^{-1} + \tau_S^{-1}$ and the constants A and C thus determined, a fitting curve (in the right-hand side view of Fig. 5, a new method fitting) fitted over a wider range of the decay curve as compared with the case where fitting is achieved by the primary mode method or the 1/e lifetime method as in the right-hand side view of Fig. 5 (in the right-had side view of Fig. 5, primary mode lifetime fitting, 1/e lifetime fitting) was obtained.

From the above results, it can be confirmed that the function of the expression (1) is the function of time close to the actually measured decay.

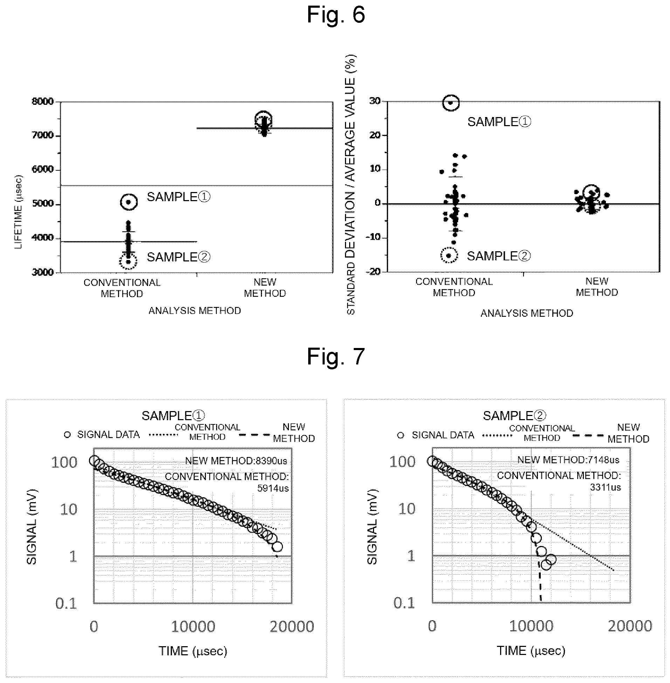

Figs. 6 and 7 each show the result of the comparison between one example (a new method) of the evaluation method of a semiconductor sample in accordance with one aspect of the present invention and a conventional method.

The left-hand side view of Fig. 6 shows the recombination lifetime value (in Fig. 6, a new method) determined by the same method as that of Example 1, and the recombination lifetime value (in Fig. 6, a "conventional method") obtained by the primary mode method of a conventional method of a plurality of n type silicon wafers that can provide a recombination lifetime value of about 7000 $\mu$sec by the same method as that of Example 1. The right-hand side view of Fig. 6 shows the CV value of the measurement results shown in the left-hand side view of Fig. 6 (standard deviation / arithmetic average x 100, unit: %). From the results shown in Fig. 6, it can be confirmed that the variations in recombination lifetime value can be more suppressed as compared with the conventional method.

Fig. 7 shows a fitting curve obtained by fitting the decay curve obtained by measurement with the $\mu$-PCD method by the expression (1), and a fitting curve obtained by fitting thereof with the primary mode method of a conventional method of a sample "circled 1" with the largest difference in the positive direction and a sample "circled 2" with the largest difference in the negative direction with the conventional method in Fig. 6. Fig. 7 also shows therein the recombination lifetime values of each sample determined by the new method and the conventional method. Also from the results shown in Fig. 7, it can be confirmed that the function of the expression (1) is the function of time close to the actually measured decay.

[Evaluation device of semiconductor sample]

One aspect of the present invention relates to, an evaluation device of a semiconductor sample, including:

> a measurement part which subjects a semiconductor sample to be evaluated to measurement with a photoconductivity decay method to acquire a decay curve;
> a processing part which subjects the decay curve to signal data processing by a model expression including an exponential decay term and a constant term; and
> a recombination lifetime calculation part which determines a recombination lifetime of the semiconductor sample from the expression of the exponential decay obtained by the signal data processing.

The above evaluation device can be used for carrying out the evaluation method of a semiconductor sample in accordance with one aspect of the present invention. The model expression can be, for example, the expression (1') described previously.

In order to carry out the evaluation method of a semiconductor sample in accordance with one aspect of the present invention, the processing part of the above evaluation device performs signal data processing, and thereby cancels the constant term in the model expression for acquiring the expression of the exponential decay, and can determine the time constant $\tau_B^{-1} + \tau_S^{-1}$ from the expression of the exponential decay. The above processing part can be configured using a known analysis program. Further, the above recombination lifetime calculation part can also be configured using a known analysis program.

Further, the above signal data processing can include repetition of an operation of sampling a time series signal modeled by the model expression, and taking a difference.

Further, the above processing part can carry out auto scaling for determining the sampling region for performing the sampling. The above processing part can determine the region, where the influence of the recombination is small and the influence of noise is small, as the sampling region by the auto scaling. Such auto scaling is as described previously.

In one embodiment, in the above evaluation device, the PCD measurement device having a measurement part which performs measurement with the PCD method can further include the above processing part and/or the above calculation part. Further, in another embodiment, one or more computer different from the PCD measurement device having a measurement part which performs measurement with the PCD method includes the above processing part and/or the above calculation part, so that various information such as a measurement result, a processing result, and a calculation result can be transmitted and received by wire communication or radio communication between such a computer and the PCD measurement device, or further between a plurality of computers and the PCD measurement device. One computer may include the above processing part and the above calculation part, or different computers may include the above processing part and the above calculation part, respectively.

[Method of manufacturing semiconductor wafer]

One aspect of the present invention relates to, a method of manufacturing a semiconductor wafer (which will be hereinafter also described as a "manufacturing method 1"), including:

> manufacturing a semiconductor wafer lot including a plurality of semiconductor wafers;
> extracting at least one semiconductor wafer from the semiconductor wafer lot;
> evaluating the extracted semiconductor wafer with the above evaluation method; and
> subjecting a semiconductor wafer of the same semiconductor wafer lot as that of the semiconductor wafer evaluated as a good product as a result of the evaluation to preparation for shipment as a product semiconductor wafer.

Further, one aspect of the present invention relates to,
a method of manufacturing a semiconductor wafer (which will be hereinafter also described as a "manufacturing method 2"), including:

> manufacturing a semiconductor wafer to be evaluated under a test manufacturing condition;
> evaluating the manufactured semiconductor wafer to be evaluated with the above evaluation method of a semiconductor sample;
> determining a manufacturing condition obtained by adding a change to the test manufacturing condition as an actual manufacturing condition, or determining the test manufacturing condition as an actual manufacturing condition based on the result of the evaluation; and
> manufacturing a semiconductor wafer under the determined actual manufacturing condition.

With the manufacturing method 1, a semiconductor wafer of the same lot as that of the semiconductor wafer determined as a good product as a result of performing a so-called sampling inspection is subjected to preparation for shipment as a product semiconductor wafer. On the other hand, with the manufacturing method 2, the semiconductor wafer manufactured under the test manufacturing condition is evaluated, so that the actual manufacturing condition is determined based on the evaluation result. With both of the manufacturing method 1 and the manufacturing method 2, evaluation of a semiconductor wafer is performed with the evaluation method in accordance with one aspect of the present invention described previously.

With the manufacturing method 1, manufacturing of a semiconductor wafer lot can be performed in the same manner as with the common manufacturing method of a semiconductor wafer. For example, examples of a silicon wafer, which is one embodiment of a semiconductor wafer, may include a polished wafer. A polished wafer can be manufactured by manufacturing steps including cutting (slicing) of a silicon wafer from a silicon single crystal ingot grown with the Czochralski method (CZ method), or the like, chamfering processing, rough grinding (for exmple, lapping), etching, mirror polishing (finish polishing), and cleaning to be performed between the processing steps or after the processing steps. Further, an annealed wafer can be manufactured by subjecting the polished wafer manufactured as described above to a heat treatment, particularly, an annealing treatment. An epitaxial wafer can be manufactured by gas-phase growing (epitaxially growing) of an epitaxial layer on the surface of the polished wafer manufactured as described above.

The total number of the semiconductor wafers included in the semiconductor wafer lot has no particular restriction. The number of the semiconductor wafers to be extracted from the manufactured semiconductor wafer lot, and to be subjected to a so-called sampling inspection is at least 1, and may be 2 or more. The number has no particular restriction.

The semiconductor wafer extracted from the semiconductor wafer lot is evaluated with the evaluation method in accordance with one aspect of the present invention. Whether the evaluated semiconductor wafer is good or bad can be determined with the recombination lifetime value determined by such evaluation as an index. For example, the recombination lifetime measured with the PCD method decreases with an increase in metal contamination amount. Therefore, the occurrence or non-occurrence of metal contamination and/or the degree of metal contamination of the semiconductor wafer can be evaluated based on the value of the recombination lifetime measured with the PCD method. Therefore, for example, the value of the recombination lifetime being equal to or larger than a prescribed threshold value, or exceeding the threshold value can be set as the criterion for a good product. Such a threshold value may be set according to the quality required of a product wafer. The semiconductor wafer of the same semiconductor wafer lot as that of the semiconductor wafer determined as a good product can be subjected to preparation for shipment as a product semiconductor wafer (for example, packing).

As for the manufacturing method 2, as the test manufacturing condition and the actual manufacturing condition, mention may be made of various conditions in various steps for manufacturing a semiconductor wafer.

For various steps for manufacturing a semiconductor wafer, details are as described for the manufacturing method 1 previously. The term "actual manufacturing condition" means the manufacturing condition of a product semiconductor wafer.

As for the manufacturing method 2, as the preliminary step for determining the actual manufacturing condition, the test manufacturing condition is set, and a semiconductor wafer to be evaluated is manufactured under the test manufacturing condition. The manufactured semiconductor wafer is evaluated with the evaluation method in accordance with one aspect of the present invention. With the recombination lifetime value determined by such evaluation as an index, it is possible to determine whether the test manufacturing condition is the condition that can be adopted as the actual manufacturing condition, or the manufacturing condition obtained by adding a change to the test manufacturing condition should be adopted as the actual manufacturing condition. For example, from the same viewpoint as the viewpoint previously described for the manufacturing method 1, the value of the determined recombination lifetime being equal to or larger than a prescribed threshold value, or exceeding the threshold value can be set as the criterion for whether the test manufacturing condition can be adopted as the actual manufacturing condition, or not. Examples of the manufacturing condition to be changed as a result of the determination may include manufacturing conditions that can cause metal contamination. Examples thereof may include repair of a heat treatment furnace to be used (for example, replacement of a component, cleaning of a component, or cleaning of the inside of the furnace).

To other details of the manufacturing method 1 and the manufacturing method 2, a known technology regarding a method of manufacturing a semiconductor wafer is applicable. With the manufacturing method 1 and the manufacturing method 2, for example, a product semiconductor wafer with less metal contamination can be commercially supplied with stability.

One aspect of the present invention is useful in the technical field of various semiconductor wafers.

**Claims**

1. An evaluation method of a semiconductor sample, comprising:

subjecting a semiconductor sample to be evaluated to measurement with a photoconductivity decay method to acquire a decay curve;
subjecting the decay curve to signal data processing by a model expression including an exponential decay term and a constant term; and
determining a recombination lifetime of the semiconductor sample from an expression of exponential decay obtained by the signal data processing.

2. The evaluation method of a semiconductor sample according to claim 1, further comprising:

   performing the signal data processing to cancel the constant term in the model expression to acquire the expression of exponential decay; and determining a time constant $\tau_B^{-1} + \tau_S^{-1}$ from the expression of exponential decay, where $\tau_B$ is a SRH recombination lifetime, and $\tau_S$ is a surface recombination lifetime.

3. The evaluation method of a semiconductor sample according to claim 2, wherein the signal data processing comprises repetition of an operation of sampling a time series signal modeled by the model expression to obtain a difference.

4. The evaluation method of a semiconductor sample according to claim 3, further comprising: carrying out auto scaling for determining a sampling region for performing the sampling.

5. The evaluation method of a semiconductor sample according to claim 4, wherein the auto scaling determines a region, where an influence of auger recombination is small and an influence of noise is small, as the sampling region.

6. The evaluation method of a semiconductor sample according to any of claims 1 to 5, wherein the model expression is expression (1') below:

$$xi(ti) = A \times \exp[-(\tau_B^{-1} + \tau_S^{-1})ti] - C \;\cdots\; (1')$$

   (in the expression (1'), ti: elapsed time after excitation light irradiation, xi(ti): signal intensity at elapsed time ti, $\tau_B$: SRH recombination lifetime, $\tau_S$: surface recombination lifetime, A, C: constant).

7. An evaluation device of a semiconductor sample, comprising:

   a measurement part which subjects a semiconductor sample to be evaluated to measurement with a photoconductivity decay method to acquire a decay curve;
   a processing part which subjects the decay curve to signal data processing by a model expression including an exponential decay term and a constant term; and
   a recombination lifetime calculation part which determines a recombination lifetime of the semiconductor sample from an expression of exponential decay obtained by the signal data processing.

8. The evaluation device of a semiconductor sample according to claim 7, wherein the processing part executes:

   performing the signal data processing to cancel the constant term in the model expression to acquire the expression of exponential decay; and determining a time constant $\tau_B^{-1} + \tau_S^{-1}$ from the expression of exponential decay, where $\tau_B$ is a SRH recombination lifetime, and $\tau_S$ is a surface recombination lifetime.

9. The evaluation device of a semiconductor sample according to claim 8, wherein the signal data processing comprises repetition of an operation of sampling a time series signal modeled by the model expression to obtain a difference.

10. The evaluation device of a semiconductor sample according to claim 9, wherein the processing part executes auto scaling for determining a sampling region for performing the sampling.

11. The evaluation device of a semiconductor sample according to claim 10, wherein the processing part determines a region, where an influence of auger recombination is small and an influence of noise is small, as a sampling region by the auto scaling.

12. The evaluation device of a semiconductor sample according to any of claims 7 to 11, wherein the model expression is expression (1') below:

$$xi(ti) = A \times \exp[-(\tau_B^{-1} + \tau_S^{-1})ti] - C \;\cdots\; (1')$$

   (in the expression (1'), ti: elapsed time after excitation light irradiation, xi(ti): signal intensity at elapsed time ti, $\tau_B$: SRH recombination lifetime, $\tau_S$: surface recombination lifetime, A, C: constant).

13. A method of manufacturing a semiconductor wafer, comprising:

   manufacturing a semiconductor wafer lot including a plurality of semiconductor wafers;
   extracting at least one semiconductor wafer from the semiconductor wafer lot;
   evaluating the extracted semiconductor wafer by the evaluation method according to any of claims 1 to 6; and
subjecting a semiconductor wafer of the semiconductor wafer lot, which is same as that of the semiconductor wafer evaluated as a good product as a result of the evaluation, to preparation for shipment as a product semiconductor wafer.

14. A method of manufacturing a semiconductor wafer, comprising:

manufacturing a semiconductor wafer to be evaluated under a test manufacturing condition; evaluating the manufactured semiconductor wafer to be evaluated by the evaluation method of the semiconductor sample according to any of claims 1 to 6; determining a manufacturing condition, obtained by adding a change to the test manufacturing condition, as an actual manufacturing condition, or determining the test manufacturing condition as an actual manufacturing condition, based on a result of the evaluation; and manufacturing a semiconductor wafer under the determined actual manufacturing condition.

# Fig. 1

# Fig. 2

# Fig. 3

## Fig. 4

## Fig. 5

# Fig. 6

# Fig. 7

Fig. 8

Fig. 9

○      SIGNAL DATA

·········      PRIMARY MODE LIFETIME FITTING

- - -      1/e LIFETIME FITTING

## INTERNATIONAL SEARCH REPORT

| International application No. |
| --- |
| **PCT/JP2022/035107** |

### A. CLASSIFICATION OF SUBJECT MATTER

**_H01L 21/66_**(2006.01)i
FI:   H01L21/66 M

According to International Patent Classification (IPC) or to both national classification and IPC

### B. FIELDS SEARCHED

Minimum documentation searched (classification system followed by classification symbols)

H01L21/66

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2012-195531 A (KOBE STEEL, LTD.) 11 October 2012 (2012-10-11) paragraphs [0002], [0011], [0036]-[0088], fig. 1-3 | 1, 7, 13-14 |
| A | | 2-6, 8-12 |
| A | JP 57-54338 A (IKUTOKU TECHNICAL UNIVERSITY) 31 March 1982 (1982-03-31) column 3, line 12 to column 12, line 1, fig. 1-3 | 1-14 |
| A | JP 59-55013 A (MITSUBISHI METAL CORP.) 29 March 1984 (1984-03-29) column 3, line 5 to column 13, line 9, fig. 1-7 | 1-14 |
| A | JP 2019-12740 A (KYOCERA CORP.) 24 January 2019 (2019-01-24) paragraphs [0001]-[0054], fig. 1-3 | 1-14 |
| A | JP 2013-145868 A (TOKYO UNIVERSITY OF AGRICULTURE AND TECHNOLOGY) 25 July 2013 (2013-07-25) paragraphs [0008]-[0063], fig. 1-5 | 1-14 |

☐ Further documents are listed in the continuation of Box C.          ☑ See patent family annex.

| | |
| --- | --- |
| \*      Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **08 November 2022** | **22 November 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/035107**

| Patent document cited in search report | | | Publication date (day/month/year) | Patent family member(s) | Publication date (day/month/year) |
|---|---|---|---|---|---|
| JP | 2012-195531 | A | 11 October 2012 | (Family: none) | |
| JP | 57-54338 | A | 31 March 1982 | (Family: none) | |
| JP | 59-55013 | A | 29 March 1984 | (Family: none) | |
| JP | 2019-12740 | A | 24 January 2019 | (Family: none) | |
| JP | 2013-145868 | A | 25 July 2013 | US 2014/0303919 A1 paragraphs [0007]-[0067], fig. 1-5 CN 104094389 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021183205 A
- JP 2019012740 A

- JP 58181549 A

**Non-patent literature cited in the description**

- **USAMI AKIRA ; SONE FUKUYASU ; MURAI KOUJI ; SANO KENJI.** *Laser Study,* 1984, vol. 12 (10), 585-594

- **USAMI AKIRA ; KANDATSU SHINICHI ; KUDO BOSSI.** *Applied Physics,* 1980, vol. 49 (12), 1192-1197